# EUROPÄISCHE PATENTANMELDUNG

(11) **EP 4 385 802 A1**
(43) Veröffentlichungstag der Anmeldung: **19.06.2024**
(21) Anmeldenummer: 23214479.0
(22) Anmeldetag: 06.12.2023
(51) Int. Cl.: B60L 53/10, B60L 53/16, B60L 53/302, F28D 15/00, F28D 20/02, H01B 7/42, H01L 23/42, H01L 23/473, H01R 9/11, H01R 13/04, H01R 13/10, H01R 13/533, H01R 13/66, H01R 24/28

(54) **LADEDOSE FÜR EIN FAHRZEUG**

(30) Priorität: 13.12.2022 DE 102022133099
(71) Anmelder: Lisa Dräxlmaier GmbH, 84137 Vilsbiburg (DE)
(72) Erfinder: Heckelsmüller, Stephan, 85386 Eching (DE); Tausch, Johannes, 85276 Pfaffenhofen a.d. Ilm (DE)

(57) **Zusammenfassung**

Die vorliegende Erfindung bezieht sich auf eine Ladedose (100) für ein Fahrzeug, wobei die Ladedose (100) zumindest zwei Kontaktelemente (102) mit je einem Latentwärmespeicher (108) aufweist, wobei der Latentwärmespeicher (108) ein in einem Behälter (114) angeordnetes Phasenwechselmaterial (116) aufweist, wobei der Behälter (114) thermisch mit dem jeweiligen Kontaktelement (102) gekoppelt ist und in einem Strompfad (110) zwischen dem Kontaktelement (102) und einem Anschluss (112) des Kontaktelements (102) für eine Leitung eines Leitungssatzes des Fahrzeugs angeordnet ist.

## Beschreibung

### Technisches Gebiet

Die vorliegende Erfindung betrifft eine Ladedose für ein Fahrzeug.

### Stand der Technik

Die vorliegende Erfindung wird im Folgenden hauptsächlich in Verbindung mit Ladeanschlüssen für elektrische Fahrzeuge beschrieben.

Ein elektrisch angetriebenes Fahrzeug kann eine Ladedose zum Laden einer Traktionsbatterie des Fahrzeugs aufweisen. In die Ladedose kann ein Ladestecker eines Ladekabels eingesteckt werden. Über die Ladedose kann die Traktionsbatterie von einem Ladegerät, also einer Ladesäule, einer Wallbox oder einem sogenannten Ladeziegel aufgeladen werden. In der Ladedose sind elektrische Kontaktelemente zum Herstellen einer elektrisch leitenden Verbindung zum Ladestecker angeordnet. Die Kontaktelemente können als Kontaktstifte ausgeführt sein und mit entsprechenden Gegenstücken im Ladestecker die elektrisch leitende Verbindung herstellen.

Die Verbindung weist einen Übergangswiderstand auf. Aufgrund des Übergangswiderstands fällt an der Verbindung Verlustleistung in Form von Wärme ab. Die Verlustleistung ist abhängig vom Stromfluss über die Verbindung. Bei großen Ladeleistungen können die Kontaktelemente beim Laden warm beziehungsweise heiß werden. Die Verlustleistung begrenzt also eine mögliche Ladeleistung. Die Verlustleistung kann durch höhere Ladespannungen verringert werden.

### Beschreibung der Erfindung

Eine Aufgabe der Erfindung ist es daher, unter Einsatz konstruktiv möglichst einfacher Mittel eine verbesserte Ladedose bereitzustellen. Eine Verbesserung kann hierbei beispielsweise eine verbesserte Kühlung der Kontaktelemente betreffen.

Die Aufgabe wird durch den Gegenstand des unabhängigen Anspruchs gelöst. Vorteilhafte Weiterbildungen der Erfindung sind in den abhängigen Ansprüchen, der Beschreibung und den begleitenden Figuren angegeben.

Bei dem hier vorgestellten Ansatz sind hoch belastete Kontaktelemente einer Ladedose direkt mit einem Latentwärmespeicher thermisch gekoppelt. Der Latentwärmespeicher weist eine hohe Wärmekapazität auf, da in dem Latentwärmespeicher bei einer vordefinierbaren Temperatur ein Phasenwechsel eines Phasenwechselmaterials (englisch: phase change material - PCM) einsetzt und der Phasenwechsel viel Energie benötigt. Ein Temperaturanstieg über die vordefinierte Temperatur hinaus wird durch die Energieaufnahme während des Phasenwechsels im Wesentlichen so lange verhindert, bis alles Phasenwechselmaterial seine Phase gewechselt hat. Erst nach abgeschlossenem Phasenwechsel steigt die Temperatur weiter an.

Das Phasenwechselmaterial ist hier in zwei Behältern bevorratet, die jeweils unmittelbar hinter den Kontaktelementen und damit in einem Strompfad von Hin- und Rückleitung angeordnet sind. Die Behälter weisen somit eine doppelte Funktion auf, indem sie das Phasenwechselmaterial umschließen und Strom leiten.

Durch den hier vorgestellten Ansatz kann an beziehungsweise in den Kontaktelementen entstehende Wärme sehr nahe an ihrem Entstehungsort aufgenommen werden. Durch die Anordnung der Latentwärmespeicher im Strompfad kann Material eingespart werden, da der Behälter des Latentwärmespeichers zum Leiten von Strom und Wärme verwendet wird. Zusätzlich wird durch das Phasenwechselmaterial so lange thermische Energie bei näherungsweise konstanter Temperatur aufgenommen, bis alles Phasenwechselmaterial seine Phase gewechselt hat. Wenn ausreichend Phasenwechselmaterial vorhanden ist, kann ein Temperaturanstieg über diese Temperatur hinaus verhindert werden.

Es wird eine Ladedose für ein Fahrzeug vorgeschlagen, wobei die Ladedose zumindest zwei Kontaktelemente mit je einem Latentwärmespeicher aufweist, wobei der Latentwärmespeicher ein in einem Behälter angeordnetes Phasenwechselmaterial aufweist, wobei der Behälter thermisch mit dem jeweiligen Kontaktelement gekoppelt ist und in einem Strompfad zwischen dem Kontaktelement und einem Anschluss des Kontaktelements für eine Leitung eines Leitungssatzes des Fahrzeugs angeordnet ist.

Eine Ladedose kann zumindest zwei Kontaktelemente zum Übertragen von elektrischer Energie von einem Ladekabel in ein elektrisch angetriebenes Fahrzeug aufweisen. Die Ladedose kann unterschiedliche Kontaktelemente für unterschiedliche Stromarten aufweisen. Insbesondere Gleichstrom-Kontaktelemente können gemäß dem hier vorgestellten Ansatz ausgeführt sein. Die Ladedose kann einem genormten Standard für Ladedosen entsprechen. In eingebautem Zustand können elektrische Komponenten des Fahrzeugs über einen Leitungssatz des Fahrzeugs mit der Ladedose verbunden sein. Der Leitungssatz kann zumindest zwei elektrische Leitungen aufweisen. Die Leitungen können beispielsweise Kabel oder Stromschienen sein. Jede Leitung des Leitungssatzes kann an einem eigenen Anschluss der Ladedose elektrisch leitend angeschlossen werden beziehungsweise sein. Die Anschlüsse können auf einer Innenseite der Ladedose angeordnet sein. Jeder Anschluss kann über einen eigenen Strompfad mit einem der Kontaktelemente elektrisch leitend verbunden sein.

Die Kontaktelemente können zum Ausbilden einer Steckverbindung mit entsprechenden Gegenstücken ausgebildet sein. Die Kontaktelemente der Ladedose können als Kontaktstifte ausgebildet sein, die mit entsprechenden Hülsen als die Gegenstücke die Steckverbindung ausbilden können. Die Gegenstücke beziehungsweise Hülsen können in einem Ladestecker angeordnet sein. Die Kontaktelemente können aus einem Metallmaterial sein. Das Metallmaterial kann insbesondere ein Kupfermaterial sein.

Die Kontaktelemente können als Wärmequellen bezeichnet werden, da aufgrund eines Übergangswiderstands der Steckverbindungen und eines inneren Widerstands Wärme entsteht, wenn Strom über die Steckverbindung fließt. Damit am Kontaktelement entstehende Wärme abgeführt werden kann, ist ein Temperaturgefälle zwischen der Wärmequelle und einer Wärmesenke erforderlich.

Die Wärmesenke ist hier ein Latentwärmespeicher. Der Latentwärmespeicher beinhaltet ein Phasenwechselmaterial. Das Phasenwechselmaterial wechselt innerhalb eines vordefinierten Temperaturbereichs zwischen einer Festphase und einer Flüssigphase. Das Phasenwechselmaterial kann während des Phasenwechsels Energie aufnehmen oder abgeben, ohne dass seine Temperatur dabei wesentlich steigt oder fällt. Die während des Phasenwechsels aufgenommene Energie kann als latente Wärme bezeichnet werden.

Das Phasenwechselmaterial kann beispielsweise ein Paraffinmaterial oder ein Salzmaterial sein. Der Temperaturbereich des Phasenwechsels kann durch eine Zusammensetzung des Phasenwechselmaterials bestimmt werden. Der Temperaturbereich kann so eingestellt sein, dass das Kontaktelement nicht heißer als eine gewünschte Zieltemperatur wird.

Ein Behälter für das Phasenwechselmaterial kann aus einem Metallmaterial mit elektrisch leitenden und wärmeleitenden Eigenschaften bestehen. Der Behälter kann beispielsweise aus einem Aluminiummaterial oder einem Kupfermaterial sein. Der Behälter kann direkt mit dem Kontaktelement verbunden sein. Der Behälter kann elektrisch leitend und thermisch leitend mit dem Kontaktelement verbunden sein. Der Behälter kann Teil des Strompfads zu dem Anschluss für das Kabel des Kabelsatzes sein. Wenn elektrischer Strom von dem Kontaktelement zu dem Anschluss fließt, ist der Behälter stromdurchflossen.

Das Kontaktelement kann aus einer Wand des Latentwärmespeichers vorstehen. Die Wand kann Teil des Behälters sein. Das Kontaktelement kann möglichst nahe an dem Latentwärmespeicher angeordnet sein. So ist ein resultierender Wärmepfad zwischen dem Kontaktelement und dem Latentwärmespeicher kurz und weist einen geringen Wärmewiderstand auf.

Das Kontaktelement kann einen normierten Steckbereich beziehungsweise Kontaktbereich und einen Übergangsbereich zum Latentwärmespeicher aufweisen. Der Übergangsbereich kann einen größeren Leitungsquerschnitt als der Steckbereich aufweisen. Ein Leitungsquerschnitt des Kontaktelements kann im normierten Steckbereich durch den Standard vorgegeben sein. Der Steckbereich kann ein Flaschenhals für die abzuführende Wärme sein. Durch einen dickeren Übergangsbereich kann der Übergangsbereich einen geringeren Wärmewiderstand als der Steckbereich aufweisen. Dadurch kann die Wärme durch den Übergangsbereich schnell zum Latentwärmespeicher fließen.

Das Kontaktelement kann mit dem Latentwärmespeicher verschweißt sein. Alternativ kann das Kontaktelement mit dem Latentwärmespeicher verschraubt sein. Durch Schweißen kann ein sehr geringer Wärmewiderstand zwischen dem Kontaktelement und dem Behälter erreicht werden. Das Kontaktelement kann durch Laserschweißen mit dem Behälter verschweißt sein. Dabei können insbesondere gleiche oder ähnliche Metallmaterialien durch Laserschweißen verschweißt werden. Beispielsweise können Kupfermaterialien gut durch Laserschweißen miteinander verschweißt werden.

Das Kontaktelement kann durch Reibschweißen mit dem Latentwärmespeicher verschweißt sein. Durch Reibschweißen können unterschiedliche Materialien stoffschlüssig miteinander verschweißt werden. Beispielsweise kann durch Reibschweißen das Kontaktelement aus Kupfermaterial an den Behälter aus Aluminiummaterial geschweißt werden.

Das Kontaktelement und der Anschluss können auf gegenüberliegenden Seiten des Latentwärmespeichers angeordnet sein. Der Latentwärmespeicher kann zwischen dem Kontaktelement und dem Anschluss angeordnet sein. Der Strompfad kann von der einen Seite zur anderen Seite durch den Latentwärmespeicher verlaufen.

Der Behälter kann einen dicht verschweißten Deckel aufweisen. Durch einen verschweißten Deckel kann das Phasenwechselmaterial hermetisch in dem Behälter eingeschlossen sein. Durch den verschweißten Deckel können keine Fremdstoffe in das Phasenwechselmaterial gelangen. So kann die Temperatur des Phasenwechsels konstant bleiben. Der Deckel kann alternativ eine Dichtung aufweisen. Der Deckel kann auch verschraubt oder verpresst sein.

Der Behälter kann druckfest sein. Das Phasenwechselmaterial kann bei einer Volumenänderung Druck im Behälter aufbauen. Die Volumenänderung kann durch eine Temperaturänderung und/oder den Phasenwechsel ausgelöst werden. Der Behälter kann so dimensioniert sein, dass er sich unter dem resultierenden Druck nicht oder zumindest nicht wesentlich verformt. Alternativ kann der Behälter ein Druckausgleichselement aufweisen.

Der Behälter kann auf einer Innenseite Rippen zum Vergrößern einer Wärmeübergangsfläche zum Phasenwechselmaterial aufweisen. Der Behälter kann verrippt sein. Der Behälter kann aus Druckguss bestehen. Im Druckguss können auch dünne Rippen gut hergestellt werden. Alternativ kann der Behälter mit einer geringeren Anzahl dickerer Rippen durch Fließpressen hergestellt werden. Durch die Rippen kann eine begrenzte Wärmeleitfähigkeit des Phasenwechselmaterials durch eine hohe Wärmeleitfähigkeit der Rippen ausgeglichen werden. Die Wärme kann durch die Rippen in ein Volumen des Phasenwechselmaterials hineingeleitet werden.

Die beiden bzw. mehreren Latentwärmespeicher können elektrisch voneinander isoliert sein. Die Latentwärmespeicher können im Betrieb auf unterschiedlichen elektrischen Potenzialen liegen. Beispielsweise können die Latentwärmespeicher auf einem Pluspotenzial und einem Minuspotenzial einer Traktionsbatterie des Fahrzeugs liegen. Zwischen den Latentwärmespeichern können die für eine Auslegungsspannung erforderlichen Luft- und Kriechstrecken vorgehalten werden. Die Latentwärmespeicher können auch durch einen dazwischen angeordneten elektrischen Isolator isoliert sein.

### Kurze Figurenbeschreibung

Nachfolgend werden vorteilhafte Ausführungsbeispiele der Erfindung unter Bezugnahme auf die begleitenden Figuren erläutert. Es zeigen:
Fig. 1 zeigt eine Schnittdarstellung einer Ladedose gemäß einem Ausführungsbeispiel;
Fig. 2 zeigt eine räumliche Darstellung von zwei mit Latentwärmespeichern gekoppelten Kontaktelementen einer Ladedose gemäß einem Ausführungsbeispiel;
Fig. 3 zeigt eine räumliche Darstellung eines Behälters eines Latentwärmespeichers für eine Ladedose gemäß einem Ausführungsbeispiel; und
Fig. 4 zeigt eine räumliche Darstellung eines Latentwärmespeichers für eine Ladedose gemäß einem Ausführungsbeispiel.

Die Figuren sind schematische Darstellungen und dienen nur der Erläuterung der Erfindung. Gleiche oder gleichwirkende Elemente sind durchgängig mit den gleichen Bezugszeichen versehen.

### Detaillierte Beschreibung

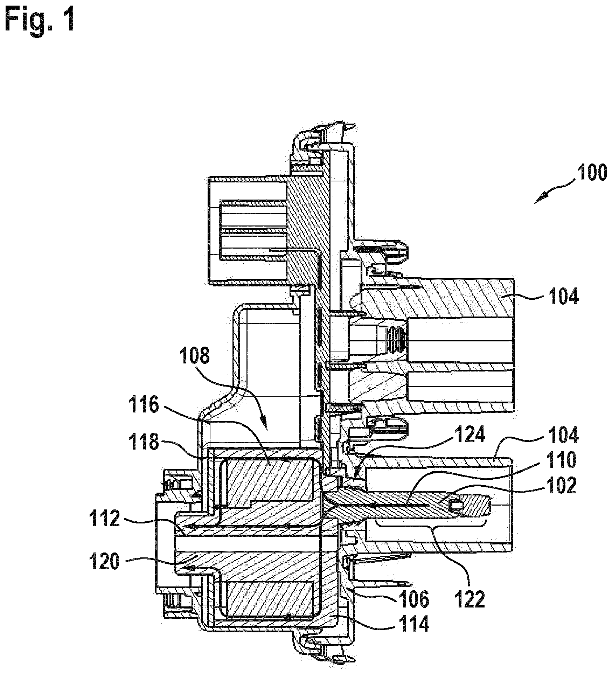

Fig. 1 zeigt eine Schnittdarstellung einer Ladedose 100 für ein Fahrzeug. Die Ladedose 100 weist zumindest zwei Kontaktelemente 102 zum Übertragen von elektrischem Strom auf. Die Kontaktelemente 102 sind innerhalb einer Steckgeometrie 104 eines Gehäuses 106 der Ladedose 100 berührsicher angeordnet. Hier sind die Kontaktelemente 102 Gleichstromkontakte der Ladedose 100 und in einer Gleichstrom-Steckgeometrie der Ladedose 100 angeordnet. Wechselstrom kontakte der Ladedose 100 sind neben der Gleichstrom-Steckgeometrie in einer eigenen Steckgeometrie 104 angeordnet.

Die Kontaktelemente 102 sind jeweils mit einem Latentwärmespeicher 108 thermisch und elektrisch gekoppelt. Der Latentwärmespeicher 108 ist in einem Strompfad 110 des jeweiligen Kontaktelements 102 zu rückseitigen Anschlüssen 112 für elektrische Leitungen eines Leitungssatzes des Fahrzeugs angeordnet.

Der Latentwärmespeicher 108 weist einen elektrisch leitenden Behälter 114 auf, der Teil des Strompfads 110 ist. Der Behälter 114 bildet einen Innenraum aus, in dem ein Phasenwechselmaterial 116 angeordnet ist. Das Phasenwechselmaterial 116 wird bei Erwärmung auf eine Phasenwechseltemperatur flüssig und erstarrt bei Abkühlung unter die Phasenwechseltemperatur wieder. Die Phasenwechseltemperatur wird dabei so lange nicht wesentlich überschritten beziehungsweise unterschritten, bis alles Phasenwechselmaterial 116 flüssig beziehungsweise fest ist.

Der Behälter 114 ist durch einen Deckel 118 dicht verschlossen. Der Deckel 118 ist plattenförmig und bildet eine von dem Kontaktelement 102 abgewandte Rückseite des Latentwärmespeichers 108 beziehungsweise des Behälters 114 aus. Der Innenraum ist nicht vollständig mit dem Phasenwechselmaterial 116 aufgefüllt. Ein verbleibender Hohlraum gleicht Volumenänderungen des Phasenwechselmaterials 116 aus.

Der Anschluss 112 ist auf einem zentral durch den Behälter 114 verlaufenden Dom 120 angeordnet. Der Deckel 118 weist eine Aussparung für den Dom 120 auf. Der Dom 120 steht über den Deckel 118 über. Der Dom 120 bildet eine Kontaktfläche für einen elektrischen Leiter des Leitungssatzes, also beispielsweise einen Kabelschuh eines Kabels beziehungsweise einen Anschluss einer Stromschiene aus. Der Dom 120 weist ferner eine zentrale Gewindebohrung zum Anschrauben des Kabels beziehungsweise des Kabelschuhs auf.

Das Kontaktelement 102 ist an den Behälter 114 angeschweißt. Die Schweißverbindung weist eine hohe elektrische Leitfähigkeit und eine hohe thermische Leitfähigkeit auf. Das Kontaktelement 102 ist seitlich versetzt zum Dom 120 an den Behälter 114 angeschweißt. Das Kontaktelement 102 ist aus einem Kupfermaterial und der Behälter 114 ist hier aus einem Aluminiummaterial. Das Kontaktelement 102 und der Behälter 114 sind durch Reibschweißen miteinander verschweißt. Der Deckel 118 ist ebenfalls aus einem Aluminiummaterial und durch Laserschweißen mit dem Behälter 114 verschweißt.

Das Kontaktelement 102 weist einen normierten Steckbereich 122 und einen kurzen Übergangsbereich 124 auf. Der Übergangsbereich 124 ist zwischen dem Steckbereich 122 und dem Latentwärmespeicher 108 angeordnet. Der Übergangsbereich 124 ist im Bereich einer Wand des Gehäuses 106 der Ladedose 100 angeordnet. Der Latentwärmespeicher 108 ist direkt hinter der Wand angeordnet. Der Übergangsbereich 124 weist eine größere Querschnittsfläche als der Steckbereich 122 auf. Dadurch weist der Übergangsbereich 124 einen geringeren elektrischen Widerstand und einen geringeren thermischen Widerstand als der Steckbereich 122 auf. Am Steckbereich 122 entstehende Wärme kann durch den verdickten Übergangsbereich 124 schnell zum Latentwärmespeicher 108 abgeleitet werden.

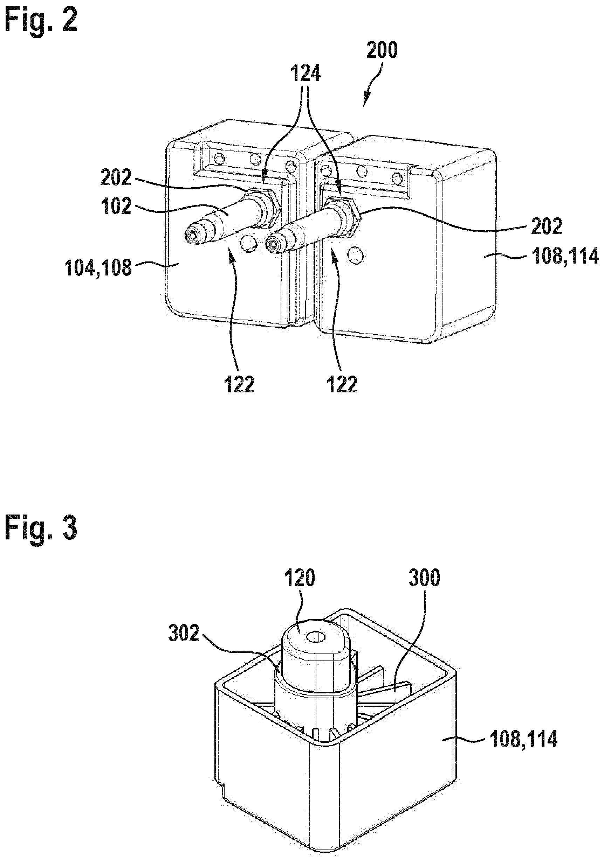

Fig. 2 zeigt eine räumliche Darstellung von zwei mit Latentwärmespeichern 108 gekoppelten Kontaktelementen 102 einer Ladedose gemäß einem Ausführungsbeispiel. Die Kontaktelemente 102 und Latentwärmespeicher 108 entsprechen im Wesentlichen der Darstellung in Fig. 1. Die Behälter 114 sind hier quaderförmig. Zwischen den Behältern 114 ist ein Spalt 200 für einen elektrischen Isolator angeordnet, da die Behälter 114 im Betrieb auf unterschiedlichen elektrischen Potenzialen liegen.

Die Kontaktelemente 102 ragen nahe an dem Spalt 200 außermittig aus Vorderseiten der Latentwärmespeicher 108. Dabei sind die Kontaktelemente 102 durch einen genormten Abstand voneinander beabstandet.

Die Kontaktelemente 102 weisen jeweils einen Antriebssechskant 202 auf, über den sie beim Reibschweißen an die Latentwärmespeicher 108 in Rotation versetzt worden sind. Der Antriebssechskant 202 ist jeweils im verdickten Übergangsbereich 124 angeordnet. Durch den Antriebssechskant 202 kann eine Beschädigung des Steckbereichs 122 beim Reibschweißen ausgeschlossen werden.

Fig. 3 zeigt eine räumliche Darstellung eines Behälters 114 eines Latentwärmespeichers 108 für eine Ladedose gemäß einem Ausführungsbeispiel. Der Behälter 114 entspricht im Wesentlichen einem der Behälter in Fig. 2. Hier ist die Rückseite des Latentwärmespeichers 108 ohne den Deckel dargestellt. Durch den Innenraum des Behälters erstreckt sich wie in Fig. 1 der Dom 120. Zwischen dem Dom 120 und Seitenwänden des Behälters 114 sind Rippen 300 angeordnet. Die Rippen 300 verlaufen hier radial zum Dom 120.

Der Dom 120 weist einen Absatz 302 für den Deckel auf. Zum Verschweißen wird der Deckel auf den Absatz 302 und eine umlaufende Kante der Seitenwände aufgelegt und mit dem Absatz 302 und der Kante verschweißt. Dadurch ist der Behälter 114 druckfest verschlossen.

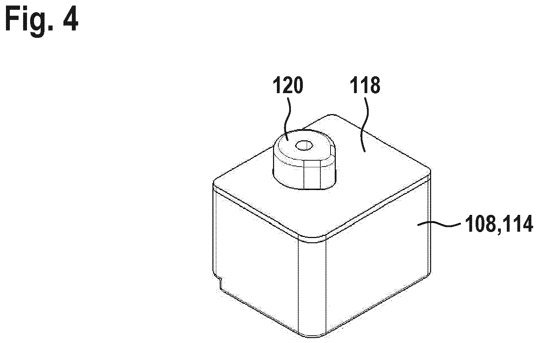

Fig. 4 zeigt eine räumliche Darstellung eines Latentwärmespeichers 108 für eine Ladedose gemäß einem Ausführungsbeispiel. Der Latentwärmespeicher 108 entspricht im Wesentlichen den vorhergehenden Darstellungen. Hier ist der Behälter 114 durch den Deckel 118 druckfest verschlossen. Der Deckel 118 ist auf die Rückseite des Latentwärmespeichers 108 aufgeschweißt und verschließt die Öffnung des Behälters vollständig. Der Dom 120 ragt durch eine Aussparung des Deckels 118.

Nachfolgend werden mögliche Ausgestaltungen der Erfindung nochmals zusammengefasst bzw. mit einer geringfügig anderen Wortwahl dargestellt.

Es wird ein Kühlkörper mit Latentwärmespeicher für kurzzeitige Peak-Belastung in Ladedosen vorgestellt.

Durch die rasante Entwicklung der Batterietechnologie steigen die maximalen Ladeleistungen von Elektrofahrzeugen von einer Modellgeneration zur nächsten teilweise um ein Vielfaches. Für die zukünftigen Fahrzeuge können Ladeströme von 732 bis 1000 Ampere für wenige Minuten erforderlich sein. Etablierte Ladestandards wie CCS1, CCS2 oder Chademo wurden für bis zu 500 Ampere ausgelegt. Da die Verlustleistung quadratisch mit der Stromstärke zunimmt, würden die normativen Temperaturgrenzen frühzeitig überschritten werden. Der hier vorgestellte Ansatz verzögert den Temperaturanstieg im Kontaktbereich wesentlich, sodass das Ladesystem die Anforderungen erfüllt.

Die etablierten Ladestandards sehen Stift- und Buchsenkontakte vor, wobei jeweils der eine in der fahrzeugseitigen Ladedose und der andere im infrastrukturseitigen Ladestecker positioniert ist. Bei dem hier vorgestellten Ansatz ist der zugehörige Stift- oder Buchsenkontakt in der Ladedose insbesondere stoffschlüssig mit einem metallischen Hohlkörper/Kühlkörper verbunden, welcher sowohl zur Übertragung des Stroms als auch zur Speicherung der thermischen Energie dient. Der Hohlkörper ist mit einem Phase Change Material (PCM) gefüllt. Dadurch, dass das PCM in einem engen Temperaturfenster, z.B. 60 bis 70 °C, seine Phase von fest zu flüssig ändert, kann es den Großteil der Verlustwärme aufnehmen. Um den Kühleffekt zu maximieren, kann der Stiftkontakt nach dem normativ definierten Bereich einen deutlich aufgeweiteten Leitungsquerschnitt bzw. durch eine geringe Länge den thermischen Widerstand zwischen Kontaktbereich und Kühlkörper minimieren. Durch eine Rippenstruktur im Kühlkörper kann die Wärme sehr schnell in das PCM übertragen werden. Nach einem Ladevorgang mit maximaler Leistung kann der Großteil des PCM-Volumens geschmolzen sein. Der Zeitraum bis zur nächsten Schnellladung ist typischerweise so groß, dass das PCM wieder fest wird und erneut als Pufferspeicher zur Verfügung steht.

Durch den hier vorgestellten Ansatz können kürzere Ladestopps an der vorhandenen Ladeinfrastruktur erreicht werden. Gegenüber alternativen Konzepten weist die Ladedose gemäß dem hier vorgestellten Ansatz weniger Bauteile und Montageschritte auf und ist dadurch kostengünstiger. Bei dem hier vorgestellten Ansatz wird eine verbesserte thermische Anbindung des PCM an stromführende Bauteile erreicht, was zu einem verbesserten Ansprechverhalten führt. In dem Hohlkörper kann ein vergrößertes PCM-Volumen bevorratet werden, was zu einem vergrößerten Effekt führt. Gegenüber Konzepten mit metallischen Kühlkörpern können durch den hier vorgestellten Ansatz deutlich weniger Gewicht und Bauraumbedarf erreicht werden. Gegenüber Konzepten mit aktiver Durchspülung ist der hier vorgestellte Ansatz ein autarkes System, bei dem keine Auslegung der Schnittstelle zum Fahrzeug nötig ist. Zusätzlich ist der hier vorgestellte Ansatz wenig fehleranfällig.

Es ist der klare Trend erkennbar, dass die Ladeleistungen von Elektrofahrzeugen in den nächsten Jahren ansteigen. Für die künftigen Elektroauto-Plattformen werden sehr hohe Ladeströme gefordert. Beispielsweise werden 732 A, 800 A und 1000 A gefordert. Bei derart hohen Stromstärken werden die Batterien innerhalb von ca. 5 bis 10 Minuten fast voll sein.

Die aktuellen Ladestandards, z.B. CCS1, CCS2 oder Chademo wurden für Stromstärken von bis zu 500 Ampere ausgelegt. Die Kontaktierung von Fahrzeug zu Infrastruktur erfolgt stets über ein System aus Kontaktstift und Kontaktbuchse mit definierten Durchmessern, z.B. 8 mm bei CCS2. Während bei den Zuleitungen auf höhere Leitungsquerschnitte und/oder effizientere aktive Kühlungssysteme gesetzt wird, stellt der Übergang Stift-Buchse einen thermischen Flaschenhals dar. Der elektrische Übergangswiderstand von markttypischen Stift-Buchse-Systemen beträgt im Neuzustand ca. 20 bis 30 µOhm, im verschlissenen Zustand auch deutlich mehr. Im Worst- Case ist die Beschichtung der Kontaktelemente abgerieben, sodass das Grundmaterial, typischerweise Kupfer, oxidiert und den Widerstand signifikant anhebt. Auch die Verschmutzung der Kontaktsysteme stellt einen Risikofaktor dar. Bei 1000 Ampere entsteht selbst im Neuzustand eine Verlustleistung von 20 bis 30 Watt an einer Kontaktstelle, das bedeutet 40 bis 60 Watt je Ladedose. Durch den geringen Querschnitt von Stift- und Buchsenelementen muss noch eine Wärmequelle des Ohm'schen Materialwiderstands von 5 bis 20 Watt je Kontaktstelle berücksichtigt werden. Bei dem hier vorgestellten Ansatz wird diese Verlustenergie durch einen Kühlkörper mit viel thermischer Masse aufgenommen, sodass der Temperaturanstieg an der Kontaktstelle nicht größer ist als der Temperaturanstieg an den Anschlussleitungen im Fahrzeug. Aufgrund des gleichmäßigen Temperaturanstiegs können die Anschlussleitungen schlanker dimensioniert werden, was Bauraum, Gewicht und Kosten reduziert. Zudem trägt der hier vorgestellte Ansatz zur Sicherheit des Ladevorgangs bei. Dadurch dass Wärme aus der Kontaktstelle abgeleitet wird, können die Temperatursensoren zur Überwachung des Ladeprozesses dem tatsächlichen Temperaturverlauf mit geringerer Abweichung folgen. Insbesondere bei gealterten oder beschmutzten Kontaktelementen kann diese Abweichung sehr groß sein. Durch den hier vorgestellten Ansatz kann ein Sicherheitsrisiko von gealterten oder beschmutzten Kontaktelementen verringert werden und beispielsweise ein Fahrzeugbrand verhindert werden. Herkömmlicherweise kann durch die kurzzeitig hohe Belastung ohne aktive Kühlmaßnahmen nur eine unwesentliche Wärmemenge an den Bauraum abgegeben werden. Der überwiegende Teil der generierten Wärme ist herkömmlicherweise nach dem Ladeprozess in Form von thermischer Energie in den Leitungen und Kontaktelementen gespeichert. Die erhöhte Wärmegeneration im genormten Kontaktbereich wird bei dem hier vorgestellten Ansatz durch eine zusätzliche Wärmekapazität in unmittelbarer Nähe kompensiert. Laut IEC 62196-3 soll die Temperatur der Stift- und Buchsenkontakte 90 °C nicht überschreiten. Wenn in einem Heißland von 40 °C Starttemperatur ausgegangen wird, ist der Temperaturanstieg auf 50 K begrenzt. Insbesondere in diesem Temperaturfenster ist die spezifische Wärmekapazität von Metallen wesentlich geringer als die von einem Latentwärmespeicher (Phase change material, PCM) mit geeigneter Phasenwechseltemperatur. Latentwärmespeicher haben typischerweise eine spezifische Wärmekapazität von 2 J/(g K), gegenüber 0,39 J/(g K) bei Kupfer und 0,89 J/(g K) bei Aluminium, und können zusätzlich ca. 170 bis 250 J/g bei ihrem Phasenwechsel von fest zu flüssig aufnehmen. Als PCM eignen sich sowohl organische als auch anorganische Materialien. Bei den organischen PCM ist Paraffin am weitesten verbreitet. Es sind aber auch Alkohole, Fettsäuren oder Kompositmaterialien möglich. Anorganische PCM sind in der Regel Salzhydrate, z.B. in Wasser gelöstes Natriumacetat.

Damit das nach seiner Aktivierung flüssige PCM nicht austritt, kann es in einem hermetisch dichten Hohlkörper eingeschlossen werden. Da sich alle gängigen PCM beim Phasenwechsel ausdehnen, üben sie Kräfte auf die umliegenden Bauteile bzw. Dichtungen aus. Beispielsweise wird der Hohlkörper durch das Verschweißen von zwei metallischen Bauteilen erzeugt, um diesen Belastungen Stand zu halten. Um die Anzahl der Bauteile und Montageschritte gering zu halten, leitet der Hohlkörper neben seiner Energiepufferfunktion auch den Strom. Pro Ladedose werden daher jeweils zwei Kühlkörper verbaut. Sie können mit den beiden Stift- bzw. Buchsenkontakten verschweißt werden und stellen die Schnittstelle der Ladedose an den Leitungssatz zur Verfügung. Dieser Aufbau hat den positiven Nebeneffekt, dass die Kühlkörper den verschiedenen Pinabstand bei CCS1, CCS2 etc. ausgleichen und eine einheitliche Schnittstelle zum Leitungssatz darstellen können. Das Metall des Kühlkörpers weist gute elektrische und thermische Leitfähigkeiten und eine gute Wärmekapazität bei geringen Kosten auf. In einer bevorzugten Ausführungsform wird Aluminium für den Kühlkörper verwendet. Alternativ kann Kupfer verwendet werden. Eine stoffschlüssige Verbindung mit großem Querschnitt zwischen Kontaktelement und Kühlkörper ist vorteilhaft. Bei einem Kühlkörper aus Aluminium können die Kontaktelemente beispielsweise durch Rotationsreibschweißen mit dem Kühlkörper verbunden werden. Bei einem Kühlkörper aus Kupfer ist darüber hinaus auch Laser- oder Widerstandsschweißen möglich.

Die Schnittstelle zum Leitungssatz kann beispielsweise als Schraubverbindung ausgeführt sein. Durch die Schraubverbindung kann ein einfacher Wechsel der Komponenten im Feld ermöglicht werden.

Die Fig. 1 zeigt den Aufbau einer CCS2-Ladedose mit zwei PCM-Kühlkörpern in der Schnittansicht.

Im Folgenden wird der PCM-Kühlkörper etwas näher beschrieben. Er besteht aus dem Kühlkörper, dem Kühlkörper-Deckel und dem PCM. In der bevorzugten Ausführungsform wird der Kühlkörper als Aluminium-Druckgussteil und der Kühlköper-Deckel als ebenes gestanztes Aluminium-Blech gefertigt. Dies ermöglicht große Gestaltungsmöglichkeiten bei vertretbaren Fertigungskosten. Durch die Bauteiltrennung in der dargestellten Anordnung werden Schieber beim Druckguss vermieden und eine Montage in Hauptmontagerichtung der Ladedose gewährleistet. Für die Abdichtung können an der Innenkontur und an der Außenkontur des Kühlkörper-Deckels Schweißnähte geschweißt werden. Durch den flachen, zweidimensionalen Deckel ist eine Standardlösung für die Optik zum Laserschweißen ausreichend.

Der Kühlkörper weist eine Becherform auf, sodass das PCM in flüssiger Form abgefüllt werden kann. Nach dem Abfüllen des PCM kann der Kühlkörper-Deckel aufgelegt und verschweißt werden.

Alle gängigen PCM haben eine geringe Wärmeleitfähigkeit von <= 0,7 W/(m K). Durch einen kurzen Wärmeleitpfad im PCM kann ein gutes Ansprechverhalten ermöglicht werden. Daher kann der Kühlkörper eine Vielzahl von Rippen aufweisen, was im Druckgussverfahren einfach umgesetzt werden kann. Als Alternative zum Druckgussverfahren kann der Kühlkörper auch durch Fließpressen hergestellt werden. Vorteilhaft hierbei ist die bessere elektrische und thermische Leitfähigkeit. Die Designfreiheit ist jedoch eingeschränkt. Die Radien an der Außenseite können für das Fließpressen etwas größer gestaltet werden. Die Anzahl und Höhe der Rippen kann reduziert werden. Nach dem Abdichten des PCM-Kühlkörpers kann jeweils ein Stift- oder Buchsenkontakt verschweißt werden. Aufgrund der runden Geometrie bietet sich Rotationsreibschweißen an. Dabei wird der PCM-Kühlkörper festgehalten und das Kontaktteil über einen Sechskant oder eine ähnliche Geometrie mit einem Drehmoment beaufschlagt und gegen den Kühlkörper gepresst. Dies ermöglicht eine großflächige Kontaktierung mit hervorragender Übertragung von Strom und Wärme.

Da es sich bei den vorhergehend detailliert beschriebenen Vorrichtungen und Verfahren um Ausführungsbeispiele handelt, können sie in üblicher Weise vom Fachmann in einem weiten Umfang modifiziert werden, ohne den Bereich der Erfindung zu verlassen. Insbesondere sind die mechanischen Anordnungen und die Größenverhältnisse der einzelnen Elemente zueinander lediglich beispielhaft.

### BEZUGSZEICHENLISTE

- 100: Ladedose
- 102: Kontaktelement
- 104: Steckgeometrie
- 106: Gehäuse
- 108: Latentwärmespeicher
- 110: Strompfad
- 112: Anschluss
- 114: Behälter
- 116: Phasenwechselmaterial
- 118: Deckel
- 120: Dom
- 122: Steckbereich
- 124: Übergangsbereich

- 200: Spalt
- 202: Antriebssechskant

- 300: Rippe
- 302: Absatz

## Patentansprüche

1. Ladedose (100) für ein Fahrzeug, wobei die Ladedose (100) zumindest zwei Kontaktelemente (102) mit je einem Latentwärmespeicher (108) aufweist, wobei der Latentwärmespeicher (108) ein in einem Behälter (114) angeordnetes Phasenwechselmaterial (116) aufweist, wobei der Behälter (114) thermisch mit dem jeweiligen Kontaktelement (102) gekoppelt ist und in einem Strompfad (110) zwischen dem Kontaktelement (102) und einem Anschluss (112) des Kontaktelements (102) für eine Leitung eines Leitungssatzes des Fahrzeugs angeordnet ist.

2. Ladedose (100) gemäß Anspruch 1, bei der das Kontaktelement (102) aus einer Wand des Latentwärmespeichers (108) vorsteht.

3. Ladedose (100) gemäß einem der vorhergehenden Ansprüche, bei der das Kontaktelement (102) einen normierten Steckbereich (122) und einen Übergangsbereich (124) zum Latentwärmespeicher (108) aufweist, wobei der Übergangsbereich (124) einen größeren Leitungsquerschnitt als der Steckbereich (122) aufweist.

4. Ladedose (100) gemäß einem der vorhergehenden Ansprüche, bei der das Kontaktelement (102) mit dem Latentwärmespeicher (108) stoffschlüssig verbunden ist.

5. Ladedose (100) gemäß Anspruch 4, bei der das Kontaktelement (102) durch Reibschweißen mit dem Latentwärmespeicher (108) verschweißt ist.

6. Ladedose (100) gemäß einem der vorhergehenden Ansprüche, bei der das Kontaktelement (102) und der Anschluss (112) auf gegenüberliegenden Seiten des Latentwärmespeichers (108) angeordnet sind.

7. Ladedose (100) gemäß einem der vorhergehenden Ansprüche, bei der der Behälter (114) einen dicht verschweißten Deckel (118) aufweist.

8. Ladedose (100) gemäß einem der vorhergehenden Ansprüche, bei der der Behälter (114) druckfest ist.

9. Ladedose (100) gemäß einem der vorhergehenden Ansprüche, bei der der Behälter (114) auf einer Innenseite Rippen (300) zum Vergrößern einer Wärmeübergangsfläche zum Phasenwechselmaterial (116) aufweist.

10. Ladedose (100) gemäß einem der vorhergehenden Ansprüche, bei der die Latentwärmespeicher (108) elektrisch voneinander isoliert sind.
